(19) **Europäisches Patentamt / European Patent Office / Office européen des brevets**

(11) **EP 4 741 348 A1**

(12) **EUROPEAN PATENT APPLICATION**

(43) Date of publication:
**13.05.2026 Bulletin 2026/20**

(21) Application number: **25212918.4**

(22) Date of filing: **03.11.2025**

(51) International Patent Classification (IPC):
**C01G 45/02** (2025.01)    **C01G 49/00** (2006.01)
**C01G 53/42** (2025.01)    **C01G 53/506** (2025.01)
**H01M 4/00** (2006.01)

(52) Cooperative Patent Classification (CPC):
**C01G 53/42; C01G 45/02; C01G 49/0027; C01G 53/506; H01M 4/00;** C01P 2004/61; C01P 2004/80; C01P 2006/12

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **05.11.2024 KR 20240155568**

(71) Applicant: **SAMSUNG SDI CO., LTD.**
**Yongin-si, Gyeonggi-do 17084 (KR)**

(72) Inventor: **DOO, Sungwook**
**17084 Gyeonggi-do (KR)**

(74) Representative: **Michalski Hüttermann & Partner Patentanwälte mbB**
**Kaistraße 16A**
**40221 Düsseldorf (DE)**

(54) **POSITIVE ELECTRODE FOR RECHARGEABLE LITHIUM BATTERIES AND RECHARGEABLE LITHIUM BATTERIES INCLUDING THE SAME**

(57)    Disclosed are a positive electrode for a rechargeable lithium battery, and a rechargeable lithium battery including the positive electrode. The positive electrode for a rechargeable lithium battery includes a positive electrode current collector, a first positive electrode active material layer on the positive electrode current collector and including a first positive electrode active material including a lithium iron phosphate-based compound, and a second positive electrode active material layer on the first positive electrode active material layer and that includes a second positive electrode active material including a lithium nickel-based composite oxide and a third positive electrode active material including a lithium manganese-based oxide.

FIG. 1

EP 4 741 348 A1

**Description**

**BACKGROUND**

**1. Field**

A positive electrode for a rechargeable lithium battery, and a rechargeable lithium battery including the positive electrode are disclosed.

**2. Description of the Related Art**

Rechargeable lithium batteries, which are easy to carry as well as achieve high energy density, are widely used as power sources for mobile information terminals such as, e.g., smart phones, laptops, and the like. Obtaining rechargeable lithium batteries with high safety and high capacity for the use as power sources for hybrid vehicles and electric vehicles or for storing electric power may be advantageous.

In addition, because rechargeable lithium batteries are typically required to achieve rapid charging characteristics as well as high safety, a low-cost lithium iron phosphate-based compound may constitute a positive electrode active material. However, lithium iron phosphate-based compounds have limitations in exhibiting high energy density and high capacity.

There have been attempts to form electrode plates by mixing lithium nickel-based composite oxides and lithium iron phosphate-based compounds in order to achieve high energy density, high stability, and high capacity while also increasing price competitiveness. However, when manufacturing an electrode plate by mixing a lithium nickel-based composite oxide and a lithium iron phosphate-based compound, separation of the operating voltage may occur, which reduces the capacity and deteriorates cycle-life characteristics of the battery due to deterioration of the positive electrode active material.

**SUMMARY**

Some example embodiments include a positive electrode for a rechargeable lithium battery, which improves rate capability and cycle-life characteristics without separation of operating voltages, by mixing three types of positive electrode active materials and adopting a double-layer structure, and a rechargeable lithium battery including the positive electrode.

In some example embodiments, a positive electrode for a rechargeable lithium battery includes a positive electrode current collector, a first positive electrode active material layer on the positive electrode current collector and including a first positive electrode active material including a lithium iron phosphate-based compound, and a second positive electrode active material layer on the first positive electrode active material layer and including a second positive electrode active material including a lithium nickel-based composite oxide and a third positive electrode active material including a lithium manganese-based oxide.

In some example embodiments, a rechargeable lithium battery includes the aforementioned positive electrode, negative electrode, and electrolyte.

The positive electrode for a rechargeable lithium battery according to some example embodiments includes a structurally stable, low-cost lithium iron phosphate-based positive electrode active material, a lithium nickel-based positive electrode active material having high capacity and energy density, and a low-cost lithium manganese-based positive electrode active material exhibiting capacity at a voltage of about 4 V, and adopts a double-layer structure so that an operating voltage may not be separated, and rate capability and cycle-life characteristics may be improved.

**BRIEF DESCRIPTION OF THE DRAWINGS**

FIGS. 1 to 4 are schematic views showing rechargeable lithium batteries according to some example embodiments.

FIG. 5 is a graph showing the voltage profile according to the capacity at the time of the first charge and discharge for the rechargeable lithium battery cell of Comparative Example 4 and the rechargeable lithium battery cell of Comparative Example 5.

FIG. 6 is a schematic view showing a positive electrode according to some example embodiments.

## DETAILED DESCRIPTION

Hereinafter, example embodiments are described in detail so that those of ordinary skill in the art can readily implement the example embodiments. However, this disclosure may be embodied in many different forms and is not construed as limited to the example embodiments set forth herein.

The terminology used herein is used to describe example embodiments only, and is not intended to limit the present disclosure. The singular expression includes the plural expression unless the context clearly dictates otherwise.

As used herein, "combination thereof" indicates a mixture, a laminate, a composite, a copolymer, an alloy, a blend, a reaction product, and the like of the constituents.

Herein, it should be understood that terms such as "comprises," "includes," or "have" are intended to designate the presence of an embodied feature, number, step, element, or a combination thereof, but does not preclude the possibility of the presence or addition of one or more other features, number, step, element, or a combination thereof.

In the drawings, the thickness of layers, films, panels, regions, and the like, may be exaggerated for clarity, and like reference numerals designate like elements throughout the specification. It is understood that when an element such as a layer, film, region, or substrate is referred to as being "on" another element, the element can be "directly on" the other element, or intervening elements may also be present therebetween. In contrast, when an element is referred to as being "directly on" another element, there are no intervening elements present.

In addition, "layer" herein includes not only a shape formed on the whole surface when viewed from a plan view, but also a shape formed on a partial surface.

The average particle diameter may be measured by a method known to those skilled in the art, for example, by a particle size analyzer, or by a transmission electron microscope image or a scanning electron microscope image. Alternatively, it is possible to obtain an average particle diameter value by measuring using a dynamic light scattering method, performing data analysis, counting the number of particles for each particle size range, and calculating from this. Unless otherwise defined, the average particle diameter ($D_{50}$) may indicate the diameter of particles having a cumulative volume of 50 volume% in the particle size distribution. As used herein, when a definition is not otherwise provided, the average particle diameter ($D_{50}$) indicates a diameter of particles having a cumulative volume of 50 volume% in the particle size distribution that is obtained by measuring the size (diameter or major axis length) of about 20 particles at random in a scanning electron microscope image.

Herein, "or" is not to be construed as an exclusive meaning, for example, "A or B" is construed to include A, B, A+B, and the like.

"Metal" is interpreted as a concept including ordinary metals, transition metals and metalloids (semi-metals).

When the terms "about" or "substantially" are used in this specification in connection with a numerical value, it is intended that the associated numerical value include a tolerance of ±10% around the stated numerical value. n ranges are specified, the range includes all values therebetween such as increments of 0.1%.

## Positive Electrode

In some example embodiments, a positive electrode for a rechargeable lithium battery includes a positive electrode current collector, a first positive electrode active material layer on the positive electrode current collector and including a first positive electrode active material including a lithium iron phosphate-based compound, and a second positive electrode active material layer which is on the first positive electrode active material layer and includes a second positive electrode active material including a lithium nickel-based composite oxide and a third positive electrode active material including a lithium manganese-based oxide.

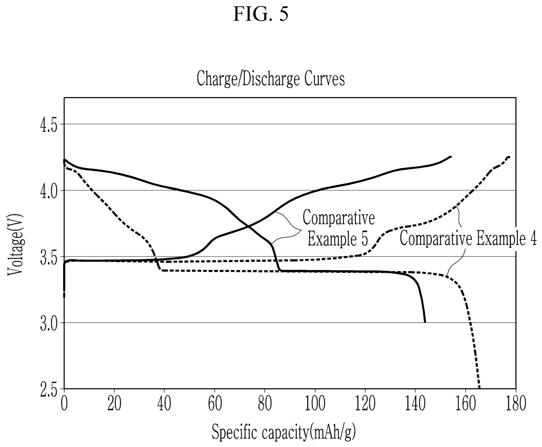

FIG. 5 is a graph showing the voltage profiles of a case where a positive electrode was manufactured by mixing a lithium iron phosphate-based compound and a lithium nickel-based composite oxide as in Comparative Example 4 described below, and a case where a positive electrode was manufactured by mixing a lithium iron phosphate-based compound, a lithium nickel-based composite oxide, and a lithium manganese-based oxide as in Comparative Example 5 also described below. In FIG. 5, in the case of the rechargeable lithium battery cell of Comparative Example 4 including a positive electrode in which a lithium iron phosphate-based compound and a lithium nickel-based composite oxide are mixed in a weight ratio of 80:20, there may be a challenge in that the driving voltage of the lithium iron phosphate-based compound is 3.4 V to 3.6 V, and the driving voltage of the lithium nickel-based composite oxide is 3.5 V to 4.25 V, so that the operating voltages are separated. Due to this separation of the driving voltages, when conducting a cycle-life test, a high current may flow through the lithium nickel-based composite oxide at a voltage of 3.5 V or higher, which may have a deleterious effect in evaluating the lithium nickel-based composite oxide at a C-rate higher than the actual C-rate. As a result, the lithium nickel-based composite oxide exhibits a capacity that is lower than the actual capacity, and deterioration may occur with repeated charge and discharge, which may reduce the cycle-life of the total cell.

In order to address the above, a method includes mixing a lithium iron phosphate-based compound and a lithium nickel-based composite oxide, while adding lithium manganese-based oxide, which is a material that exhibits capacity at a voltage that is similar to the voltage of the lithium nickel-based composite oxide. When a portion of the lithium iron phosphate-based compound is replaced with lithium manganese-based oxide, the capacity can be expressed together with the lithium nickel-based composite oxide at around 4 V, thereby alleviating the high current flow to the lithium nickel-based composite oxide. In FIG. 5, in the case of Comparative Example 5, where lithium manganese-based oxide is added to a lithium iron phosphate-based compound and a lithium nickel-based composite oxide and mixed, the performance is improved compared to the case where only the lithium iron phosphate-based compound and the lithium nickel-based composite oxide are mixed. However, even when lithium manganese-based oxide is added to and mixed with lithium iron phosphate-based compound and lithium nickel-based composite oxide, the rate capability and cycle-life characteristics are lower.

Accordingly, in some example embodiments, a double-layer structure is adopted including a first positive electrode active material layer including a first positive electrode active material including a lithium iron phosphate-based compound, a second positive electrode active material layer including a second positive electrode active material including a lithium nickel-based composite oxide, and a third positive electrode active material including a lithium manganese-based oxide. For example, the first positive electrode active material layer is under the second positive electrode active material layer, so as to improve the rate capability and cycle-life characteristics. The phenomenon of high current flow mainly occurs at high voltage, and the rate capability and cycle-life characteristics can be improved by disposing the material that exhibits capacity at high voltage at the upper portion.

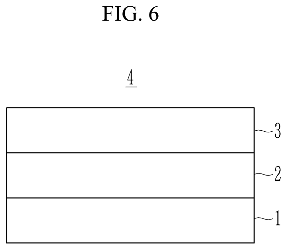

FIG. 6 is a schematic view showing a positive electrode according to some example embodiments. According to some example embodiments, the positive electrode 4 has a structure in which a positive electrode current collector 1, a first positive electrode active material layer 2, and a second positive electrode active material layer 3 are stacked, e.g., stacked in that order. However, the positive electrode is not limited to this structure, and positive electrode active material layers may be stacked on both surfaces of the positive electrode current collector, or other positive electrode active material layers or other functional layers may be added at any location.

Positive Electrode Current Collector

The positive electrode current collector is not particularly limited as long as the positive electrode current collector has conductivity and does not cause an adverse chemical change in the rechargeable lithium battery, and may be or include, for example, an aluminum (Al) thin film or a stainless steel (SUS) thin film.

First Positive Electrode Active Material Layer

The first positive electrode active material layer includes a first positive electrode active material, and the first positive electrode active material includes a lithium iron phosphate-based compound. The first positive electrode active material layer includes a first positive electrode active material including a lithium iron phosphate-based compound, thereby ensuring price competitiveness and improving energy density.

The lithium iron phosphate-based compound may be represented by, for example, Chemical Formula 1 or Chemical Formula 2.

Chemical Formula 1: $Li_{a1}Fe_{(1-x1)}M^1{}_{x1}PO_4$

In Chemical Formula 1, $0.9 \leq a1 \leq 1.5$, $0 \leq x1 \leq 0.4$, and $M^1$ is or includes at least one of Al, Ca, Ce, Cr, Cu, La, Mg, Mn, Mo, Nb, Ni, Sn, Sr, Ti, V, W, Y, Zn, Zr, or a combination thereof. Herein, $0.90 \leq a1 \leq 1.5$, for example $0.90 \leq a1 \leq 1.2$, or $0.95 \leq a1 \leq 1.1$. Additionally, $0 \leq x1 \leq 0.4$, $0 \leq x1 \leq 0.3$, $0 \leq x1 \leq 0.2$, $0 \leq x1 \leq 0.1$, or $0 \leq x1 \leq 0.05$.

Chemical Formula 2: $Li_{a2}Mn_{x2}Fe_{(1-x2-y2)}M^2{}_{y2}PO_4$

In Chemical Formula 2, $0.9 \leq a2 \leq 1.5$, $0.1 \leq x2 \leq 0.9$, $0 \leq y2 < 0.9$, and $M^2$ is or includes at least one of Al, Ca, Ce, Cr, Cu, La, Mg, Mo, Nb, Ni, Sn, Sr, Ti, V, W, Y, Zn, Zr, or a combination thereof. Herein, $0.90 \leq a2 \leq 1.5$, for example $0.90 \leq a2 \leq 1.2$, or $0.95 \leq a2 \leq 1.1$. Additionally, $0.1 \leq x2 \leq 0.9$, $0.3 \leq x2 \leq 0.9$, or $0.4 \leq x2 \leq 0.8$, $0 \leq y2 \leq 0.4$, $0 \leq y2 \leq 0.3$, $0 \leq y2 \leq 0.2$, $0 \leq y2 \leq 0.1$, or $0 \leq y2 \leq 0.05$.

For example, the lithium iron phosphate-based compound may include at least one of $LiFePO_4$, $LiMn_{0.7}Fe_{0.3}PO_4$, $LiMn_{0.6}Fe_{0.4}PO_4$, $LiMn_{0.5}Fe_{0.5}PO_4$, $LiMn_{0.4}Fe_{0.6}PO_4$, $LiMn_{0.3}Fe_{0.7}PO_4$, or a combination thereof.

For example, in Chemical Formula 1 and Chemical Formula 2, $M^1$ and $M^2$ may include at least one of Al, Mg, Ti, V, or a combination thereof.

The first positive electrode active material is in the form of particles, and may be in the form of first particles, second particles, or a mixture thereof.

The first particles may be or include secondary particles formed by agglomeration of a plurality of primary particles. The secondary particles of the first particles may have a substantially spherical or substantially ellipsoidal shape as the primary particles are closely agglomerated with each other. The secondary particles may be expressed as an assembly. The average particle diameter ($D_{50}$) of the secondary particles of the first particles may be, for example, in a range of $\geq 5\ \mu m$ to $\leq 20\ \mu m$, of $\geq 6\ \mu m$ to $\leq 20\ \mu m$, or of $\geq 6\ \mu m$ to $\leq 15\ \mu m$. The average particle diameter ($D_{50}$) of the secondary particles of the first particles may be larger than the average particle diameter ($D_{50}$) of the single particles of the second particle described later. The average particle diameter ($D_{50}$) of the primary particles forming the secondary particles of the first particles may be in a range of $\geq 0.1\ \mu m$ to $\leq 2\ \mu m$, of $\geq 0.1\ \mu m$ to $\leq 1.2\ \mu m$, or of $\geq 0.5\ \mu m$ to $\leq 0.9\ \mu m$, and for example, may be less than or equal to about 500 nm, and for example, may be in a range of $\geq 100$ nm to $\leq 400$ nm, of $\geq 120$ nm to $\leq 400$ nm, or of $\geq 140$ nm to $\leq 400$ nm.

The average particle diameter ($D_{50}$) of the secondary particles of the first particles may be, for example, obtained by randomly or non-systematically selecting about 30 first particles from an electron microscope image of the first positive electrode active material, measuring the particle diameters, and taking the diameter of the particles having a cumulative volume of 50 volume% from the particle size distribution as the average particle diameter ($D_{50}$). The average particle diameter of the primary particles forming the secondary particles of the first particles may be determined by measuring the size of about 30 primary particles in an electron microscope image of the surface or cross-section of the first particles and in the particle size distribution, the diameter of particles with a cumulative volume of 50 volume% may be taken as the average particle diameter ($D_{50}$).

The secondary particles of the first particles may include pores therein, and the porosity may be in a range of $\geq 20\%$ to $\leq 50\%$. The porosity may be obtained by measuring a ratio of the area occupied by the pores within the secondary particle to the cross-sectional area of the secondary particle using an image analysis program such as Image J, for example, from a scanning electron microscope image of the cross-section of the first particles.

The second particles may be in the form of single particles. Herein, the single particles are present alone without a grain boundary within the particle, are composed of or include one particle, and may be or include a single particle, a monolith structure, a one body structure, or a non-agglomerated particle, in which particles are not agglomerated with each other but are present as an independent phase in terms of morphology, and may be expressed as a single particle (one body particle, single grain), for example, as a single crystal. The single particles may exist alone, or may be agglomerated together. For example, about two to about ten single particles may be agglomerated together and in contact with each other. The average particle diameter ($D_{50}$) of the single particles of the second particles may be less than or equal to about 5 $\mu m$, and may be, for example, in a range of $\geq 0.5\ \mu m$ to $\leq 5\ \mu m$, of $\geq 0.6\ \mu m$ to $\leq 3\ \mu m$, of $\geq 0.7\ \mu m$ to $\leq 2\ \mu m$, or of $\geq 0.8\ \mu m$ to $\leq 1.5\ \mu m$. The average particle diameter ($D_{50}$) of the second particles may be smaller than the average particle diameter ($D_{50}$) of the secondary particles of the first particles, and may be equal to or larger than the average particle diameter ($D_{50}$) of the primary particles forming the secondary particles of the first particles. For example, the average particle diameter ($D_{50}$) of the second particles may be obtained by randomly or non-systematically selecting about 30 second particles from an electron microscope image of the first positive electrode active material, measuring the particle sizes, and taking the diameter of the particles having a cumulative volume of about 50 volume% in the particle size distribution as the average particle diameter ($D_{50}$).

Based on 100 wt% of the first positive electrode active material, an amount of the first particles may be in a range of $\geq 20$ wt% to $\leq 100$ wt%, and an amount of the second particles may be in a range of $\geq 0$ wt% to $\leq 80$ wt%. For example, an amount of the first particles may be in a range of $\geq 20$ wt% to $\leq 90$ wt%, and an amount of the second particles may be in a range of $\geq 10$ wt% to $\leq 80$ wt%. As an example, based on 100 wt% of the first positive electrode active material, an amount of the first particles may be in a range of $\geq 40$ wt% to $\leq 80$ wt% and an amount of the second particles may be in a range of $\geq 20$ wt% to $\leq 60$ wt%, or an amount of the first particles may be in a range of $\geq 40$ wt% to $\leq 60$ wt% and an amount of the second particles may be in a range of $\geq 40$ wt% to $\leq 60$ wt%.

The first positive electrode active material may further include a carbon coating layer formed on a surface of the secondary particles of the first particles, a surface of the primary particles forming the secondary particles of the first particles, and/or a surface of the single particles of the second particles. The carbon coating layer can improve the electrical conductivity of the first positive electrode active material and reduce the resistance of the positive electrode. The carbon coating layer may be formed using at least one carbon raw material such as or including, for example, at least one of glucose, sucrose, lactose, starch, oligosaccharide, polyoligosaccharide, fructose, cellulose, a polymer of furfuryl alcohol, a block copolymer of ethylene and ethylene oxide, a vinyl resin, a cellulose resin, a phenol resin, a pitch resin, and a tar resin. For example, the carbon coating layer may be formed by arranging the carbon raw materials on the surface of the first positive electrode active material particles, and then performing a firing process. For example, the carbon raw material and the primary particles can be mixed and heat-treated to form a carbon coating layer on the surface of the primary particles, and then secondary particles in which the primary particles are agglomerated may be prepared through a post-process, or the carbon raw material and the secondary particles may be mixed and heat-treated to form a carbon coating layer on the surface of the secondary particles.

The carbon coating layer may be included in an amount in a range of $\geq 0.1$ wt% to $\leq 3.9$ wt% based on 100 wt% of the first particles, and the carbon coating layer may be included in an amount in a range of $\geq 0.1$ wt% to $\leq 3.9$ wt% based on 100 wt% of the second particles.

An amount of the first positive electrode active material may be in a range of ≥ 60 wt% to ≤ 99.9 wt%, of ≥ 70 wt% to ≤ 99.8 wt%, of ≥ 80 wt% to ≤ 99 wt%, of ≥ 90 wt% to ≤ 99.8 wt%, or of ≥ 90 wt% to ≤ 99 wt% based on 100 wt% of the first positive electrode active material layer.

The first positive electrode active material layer may optionally further include a first binder, a first conductive material, or a combination thereof, in addition to the aforementioned first positive electrode active material.

The first binder is configured to attach the first positive electrode active materials to each other, and to attach the first positive electrode active material to the positive electrode current collector. Examples of the first binder may include at least one of polyvinyl alcohol, carboxymethyl cellulose, hydroxypropyl cellulose, diacetyl cellulose, polyvinyl chloride, carboxylated polyvinyl chloride, polyvinyl fluoride, an ethylene oxide-containing polymer, polyvinylpyrrolidone, polyurethane, polytetrafluoroethylene, polyvinylidene fluoride, polyethylene, polypropylene, a styrene-butadiene rubber, a (meth)acrylated styrene-butadiene rubber, an epoxy resin, a (meth)acrylic resin, a polyester resin, and nylon, but are not limited thereto.

The first conductive material is included to provide conductivity to the positive electrode, and any electrically conductive material may be used as a conductive material unless the electrically conductive material causes an adverse chemical change in the battery. Examples of the first conductive material may include a carbon-based material such as at least one of natural graphite, artificial graphite, carbon black, acetylene black, Ketjen black, a carbon fiber, a carbon nanofiber, a carbon nanotube, and the like; a metal-based material of a metal powder or a metal fiber including at least one of copper, nickel, aluminum, silver, and the like; a conductive polymer such as a polyphenylene derivative; or a mixture thereof.

An amount of the first binder in the first positive electrode active material layer may be in a range of ≥ 0.1 wt% to ≤ 5 wt%, or of ≥ 0.5 wt% to ≤ 3 wt%, based on 100 wt% of the first positive electrode active material layer, and an amount of the first conductive material may be in a range of ≥ 0.1 wt% to ≤ 5 wt%, or of ≥ 0.5 wt% to ≤ 3 wt%, based on 100 wt% of the first positive electrode active material layer.

The thickness of the first positive electrode active material layer may be in a range of ≥ 20 $\mu$m to ≤ 200 $\mu$m, for example of ≥ 40 $\mu$m to ≤ 150 $\mu$m, or of ≥ 60 $\mu$m to ≤ 100 $\mu$m. The thickness of the first positive electrode active material layer may be measured by photographing a cross-section of the positive electrode using, e.g., a scanning electron microscope. In cases where the thickness of the first positive electrode active material layer is not constant, an average value of the lowest thickness and the largest thickness may be calculated, and in this case, the thickness may be an average thickness.

A loading level of the first positive electrode active material layer may be in a range of ≥ 5 mg/cm$^2$ to ≤ 25 mg/cm$^2$, for example of ≥ 5 mg/cm$^2$ to ≤ 20 mg/cm$^2$, of ≥ 5 mg/cm$^2$ to ≤ 15 mg/cm$^2$, or of ≥ 5 mg/cm$^2$ to ≤ 10 mg/cm$^2$. The loading level may refer an amount of an active material per area of an electrode.

Second Positive Electrode Active Material Layer

The second positive electrode active material layer includes a second positive electrode active material and a third positive electrode active material, wherein the second positive electrode active material includes a lithium nickel-based composite oxide, and the third positive electrode active material includes a lithium manganese-based oxide. The second positive electrode active material layer may be or include a mixed form of the lithium nickel-based composite oxide and the lithium manganese-based oxide that exhibits capacity at a high voltage. The positive electrode according to some example embodiments may improve rate capability and cycle-life characteristics of a battery by adopting a double-layer structure in which the first positive electrode active material is applied to the first positive electrode active material layer, a lower layer, and the second positive electrode active material and the third positive electrode active material are applied to the second positive electrode active material layer, an upper layer, and particularly including the lithium nickel-based composite oxide and the lithium manganese-based oxide that exhibit capacity at a high voltage in the second positive electrode active material layer, the upper layer where an electrochemical reaction the most actively occurs at the positive electrode, and including the lithium iron phosphate-based compound exhibiting capacity at relatively low voltage in the first positive electrode active material layer, the lower layer.

The lithium nickel-based composite oxide may be represented, for example, by Chemical Formula 3.

$$\text{Chemical Formula 3:} \qquad Li_{a3}Ni_{x3}M^3{}_{y3}M^4{}_{z3}O_{2-b3}X_{b3}$$

In Chemical Formula 3, $0.9 \leq a3 \leq 1.2$, $0.3 \leq x3 < 1$, $0 < y3 \leq 0.7$, $0 \leq z3 \leq 0.7$, $0.9 \leq x3+y3+z3 \leq 1.1$, and $0 \leq b3 \leq 0.1$, $M^3$ and $M^4$ each independently are or include one or more of Al, B, Ba, Ca, Ce, Co, Cr, Cu, Fe, Mg, Mn, Mo, Nb, Si, Sn, Sr, Ti, V, W, Y, Zn, and Zr, $M^3$ and $M^4$ are different elements, and X is or includes one or more of F, P, and S.

In Chemical Formula 3, $0.3 \leq x3 \leq 0.8$, $0.1 \leq y3 \leq 0.6$, and $0.1 \leq z3 \leq 0.6$; or $0.3 \leq x3 \leq 0.6$, $0.2 \leq y3 \leq 0.5$, and $0.2 \leq z3 \leq 0.5$.

The lithium nickel-based composite oxide may be represented by Chemical Formula 4 or Chemical Formula 5 as an example.

Chemical Formula 4: $Li_{a4}Ni_{x4}Co_{y4}M^5_{z4}O_{2-b4}X_{b4}$

In Chemical Formula 4, $0.9 \leq a4 \leq 1.2$, $0.3 \leq x4 < 1$, $0 < y4 \leq 0.7$, $0 \leq z4 \leq 0.7$, $0.9 \leq x4+y4+z4 \leq 1.1$, and $0 \leq b4 \leq 0.1$, $M^5$ is or includes one or more of Al, B, Ba, Ca, Ce, Cr, Cu, Fe, Mg, Mn, Mo, Nb, Si, Sn, Sr, Ti, V, W, Y, Zn, and Zr, and X is or includes at least one of F, P, S, or a combination thereof.
In Chemical Formula 4, $0.3 \leq x4 \leq 0.8$, $0.1 \leq y4 \leq 0.6$, and $0.1 \leq z4 \leq 0.6$ or $0.3 \leq x4 \leq 0.6$, $0.2 \leq y4 \leq 0.5$, and $0.2 \leq z4 \leq 0.5$.

Chemical Formula 5: $Li_{a5}Ni_{x5}Co_{y5}M^6_{z5}M^7_{w5}O_{2-b5}X_{b5}$

In Chemical Formula 5, $0.9 \leq a5 \leq 1.2$, $0.3 \leq x5 \leq 0.98$, $0.01 \leq y5 \leq 0.69$, $0.01 \leq z5 \leq 0.69$, $0 \leq w5 \leq 0.68$, $0.9 \leq x5+y5+z5+w5 \leq 1.1$, and $0 \leq b5 \leq 0.1$, $M^6$ is or includes at least one of Al, Mn, or a combination thereof, $M^7$ is or includes one or more of B, Ba, Ca, Ce, Cr, Cu, Fe, Mg, Mo, Nb, Si, Sn, Sr, Ti, V, W, Y, Zn, and Zr, and X is or includes at least one of F, P, S, or a combination thereof.
In Chemical Formula 5 $0.3 \leq x5 \leq 0.8$, $0.1 \leq y5 \leq 0.6$, $0.1 \leq z5 \leq 0.6$, and $0 \leq w5 \leq 0.5$, or $0.3 \leq x5 \leq 0.6$, $0.2 \leq y5 \leq 0.5$, $0.2 \leq z5 \leq 0.5$, and $0 \leq w5 \leq 0.3$.
The lithium nickel-based composite oxide may be or include a high nickel-based positive electrode active material. For example, in the lithium nickel-based composite oxide, a nickel content based on 100 mol% of the total metal excluding lithium may be greater than or equal to about 80 mol%, for example, greater than or equal to about 85 mol%, greater than or equal to about 90 mol%, greater than or equal to about 91 mol%, greater than or equal to about 94 mol%, and less than or equal to about 99 mol%. The high-nickel-based positive electrode active material may achieve high capacity and high performance. The high-nickel-based positive electrode active material may improve capacity, efficiency, energy density, and cycle-life characteristics by being applied to an upper layer of a first positive electrode active material layer including a first positive electrode active material including a lithium iron phosphate-based compound.
The second positive electrode active material may be in the form of secondary particles in which a plurality of primary particles are agglomerated, in the form of single particles, or in the form of a mixture thereof.
The average particle diameter ($D_{50}$) of the second positive electrode active material may be in a range of $\geq 1\ \mu m$ to $\leq 20\ \mu m$, or of $\geq 3\ \mu m$ to $\leq 18\ \mu m$. For example, the second positive electrode active material may include large particles having an average particle diameter ($D_{50}$) in a range of $\geq 9\ \mu m$ to $\leq 20\ \mu m$, of $\geq 10\ \mu m$ to $\leq 18\ \mu m$, or of $\geq 12\ \mu m$ to $\leq 15\ \mu m$, small particles having an average particle diameter ($D_{50}$) in a range of $\geq 1\ \mu m$ to $\leq 8\ \mu m$, of $\geq 1.5\ \mu m$ to $\leq 7\ \mu m$, or of $\geq 2\ \mu m$ to $\leq 6\ \mu m$, or a combination thereof. The large particles may be in the form of secondary particles in which a plurality of primary particles are agglomerated, and the small particles may be in the form of secondary particles in which a plurality of primary particles are agglomerated, in the form of single particles, or in the form of a mixture thereof. The average particle diameter ($D_{50}$) of the primary particles forming the secondary particles may be less than or equal to about 1 $\mu m$, and may be, for example, in a range of $\geq 0.1\ \mu m$ to $\leq 1\ \mu m$, of $\geq 0.2\ \mu m$ to $\leq 0.9\ \mu m$, of $\geq 0.2\ \mu m$ to $\leq 0.8\ \mu m$, or of $\geq 0.3\ \mu m$ to $\leq 0.6\ \mu m$. The average particle diameter ($D_{50}$) of the single particles may be in a range of $\geq 1\ \mu m$ to $\leq 8\ \mu m$, or of $\geq 1\ \mu m$ to $\leq 5\ \mu m$. The average particle diameter ($D_{50}$) may be determined, for example, by selecting about 20 random particles from a scanning electron microscope image, measuring the particle sizes thereof (particle diameter, major axis, or major axis length), obtaining a particle size distribution, and taking the size of particles having a cumulative volume of 50 volume% from the particle size distribution.
The second positive electrode active material may include, for example, both large particles and small particles, and in this case, the large particles and small particles may be mixed at a weight ratio in a range of about 20:80 to about 95:5. When the second positive electrode active material includes both large and small particles, the capacity, energy density, and cycle-life characteristics can be improved.
The lithium manganese-based oxide may be or include, for example, a lithium manganese-based oxide having a spinel structure with $LiMn_2O_4$ as the basic composition thereof. The lithium manganese-based oxide may further include, in addition to manganese, at least one of aluminum, magnesium, yttrium, or a combination thereof, and may not include cobalt, or may include a substantially small amount of cobalt.
The lithium manganese-based oxide may be represented, for example, by Chemical Formula 6.

Chemical Formula 6: $Li_{a6}Mn_{x6}M^8_{y6}O_{4-b6}X_{b6}$

In Chemical Formula 6, $0.9 \leq a6 \leq 1.8$, $1.7 \leq x6 \leq 2$, $0 \leq y6 \leq 0.3$, $1.9 \leq x6+y6 \leq 2.1$, and $0 \leq b6 \leq 0.1$, $M^8$ is or includes one or more of Al, B, Ba, Ca, Ce, Cr, Cu, Fe, Mg, Mo, Nb, Si, Sn, Sr, Ti, V, W, Y, Zn, and Zr, and X is or includes one or more of F, P, and S.
In Chemical Formula 6, $1.8 \leq x6 \leq 2$, and $0 \leq y6 \leq 0.2$; $1.9 \leq x6 \leq 2$, and $0 \leq y6 \leq 0.1$; or $1.7 \leq x6 < 2$, and $0 < y6 \leq 0.3$.
For example, the lithium manganese-based oxide may be represented by Chemical Formula 7.

Chemical Formula 7: $Li_{a7}Mn_{x7}Al_{y7}Mg_{z7}M^9_{w7}O_{4-b7}X_{b7}$

In Chemical Formula 7, $0.9 \leq a7 \leq 1.8$, $1.7 \leq x7 < 2.0$, $0 < y7 \leq 0.015$, $0 < z7 \leq 0.010$, $0 \leq w7 < 0.3$, $1.9 \leq x7+y7+z7+w7 \leq 2.1$, and $0 \leq b7 \leq 0.1$, $M^9$ is or includes one or more of B, Ba, Ca, Ce, Cr, Cu, Fe, Mo, Nb, Si, Sn, Sr, Ti, V, W, Y, Zn, and Zr, and X is or includes one or more of F, P, and S.

The third positive electrode active material may be in the form of secondary particles formed by agglomeration of a plurality of primary particles, single particles, or a mixed form thereof. Herein, the definition of the single particles is as described in the first positive electrode active material.

An average particle diameter ($D_{50}$) of the third positive electrode active material may be in a range of $\geq 1$ μm to $\leq 15$ μm, or of $\geq 3$ μm to $\leq 10$ μm. For example, the average particle diameter ($D_{50}$) of the secondary particles may be in a range of $\geq 5$ μm to $\leq 15$ μm, or of $\geq 5$ μm to $\leq 10$ μm, and the average particle diameter ($D_{50}$) of the primary particles forming the secondary particles may be in a range of $\geq 0.1$ μm to $\leq 5$ μm, of $\geq 0.1$ μm to $\leq 4$ μm, or of $\geq 0.1$ μm to $\leq 3$ μm. The average particle diameter ($D_{50}$) of the single particles may be less than or equal to about 10 μm, and may be, for example, in a range of $\geq 0.1$ μm to $\leq 10$ μm, of $\geq 0.5$ μm to $\leq 9.5$ μm, or of $\geq 0.7$ μm to $\leq 9$ μm. The average particle diameter ($D_{50}$) may be determined, for example, by selecting about 20 random particles from a scanning electron microscope image, measuring the particle sizes thereof (particle diameter, major axis, or major axis length), obtaining a particle size distribution, and taking the size of particles having a cumulative volume of 50 volume% from the particle size distribution. When the secondary particles and single particles are mixed, a mixing ratio of the secondary particles and single particles may be in a range of about 1:9 to about 9:1, but the present disclosure is not limited thereto.

The amount of the second positive electrode active material and the third positive electrode active material may be in a range of $\geq 60$ wt% to $\leq 99.9$ wt%, of $\geq 70$ wt% to $\leq 99.8$ wt%, of $\geq 80$ wt% to $\leq 99$ wt%, of $\geq 90$ wt% to $\leq 99.8$ wt%, or of $\geq 94$ wt% to $\leq 99$ wt% based on 100 wt% of the second positive electrode active material layer. The total content of the second positive electrode active material and the third positive electrode active material refers to the total content of the second positive electrode active material included in the second positive electrode active material layer and the third positive electrode active material included in the second positive electrode active material layer.

A weight ratio of the second positive electrode active material including the lithium nickel-based composite oxide and the third positive electrode active material including the lithium manganese-based oxide in the second positive electrode active material layer may be in a range of about 10:90 to about 90:10, for example, about 10:90 to about 80:20, about 10:90 to about 70:30, about 10:90 to about 60:40, about 10:90 to about 50:50, or about 20:80 to about 40:60. When the weight ratio of the lithium nickel-based composite oxide and the lithium manganese-based oxide in the second positive electrode active material layer satisfies the above range, rate capability and cycle-life characteristics of the battery can be improved by reducing or minimizing the amount of the expensive lithium nickel-based composite oxide, while mixing in a lithium manganese-based oxide that exhibits capacity at high voltage and is relatively inexpensive.

In the total of the first positive electrode active material layer and the second positive electrode active material layer, the first positive electrode active material may be included in an amount in a range of $\geq 10$ wt% to $\leq 70$ wt%, the second positive electrode active material may be included in an amount in a range of $\geq 10$ wt% to $\leq 50$ wt%, and the third positive electrode active material may be included in an amount in a range of $\geq 20$ wt% to $\leq 80$ wt%, based on a total of 100 wt% of the first positive electrode active material and the second positive electrode active material, and the third positive electrode active material. As an example, the first positive electrode active material may be included in an amount in a range of $\geq 30$ wt% to $\leq 50$ wt%, the second positive electrode active material may be included in an amount in a range of $\geq 10$ wt% to $\leq 30$ wt%, and the third positive electrode active material may be included in an amount in a range of $\geq 40$ wt% to $\leq 60$ wt%, based on a total of 100 wt% of the first positive electrode active material, the second positive electrode active material, and the third positive electrode active material. When the amounts of each of the first positive electrode active material, the second positive electrode active material, and the third positive electrode active material satisfy the above ranges, the manufacturing cost can be lowered to allow to manufacture a low-cost positive electrode active material, while realizing high capacity and high energy density and improving rate capability and cycle-life characteristics.

For example, in the total first positive electrode active material layer and the second positive electrode active material layer, a manganese content based on 100 mol% of the total metal excluding lithium may be in a range of $\geq 30$ mol% to $\leq 70$ mol%, for example, of $\geq 40$ mol% to $\leq 60$ mol%. In this case, the unit cost required for manufacturing a positive electrode can be lowered while improving safety, capacity characteristics, rate capability, and cycle-life characteristics.

The second positive electrode active material layer may optionally further include a second binder, a second conductive material, or a combination thereof in addition to the second positive electrode active material and the third positive electrode active material.

The binder and the conductive material are used as "first" or "second" only to distinguish the second binder and the second conductive material from the first binder and the first conductive material included in the first positive electrode active material layer, and do not necessarily indicate that they are different.

The second binder and the second conductive material may include the types of binder and conductive material normally included in the positive electrode active material layer, and because these types are described in the first binder and the first conductive material, respectively, a description thereof is omitted below.

An amount of the second binder in the second positive electrode active material layer may be in a range of $\geq 0.1$ wt% to $\leq 5$ wt%, or of $\geq 0.5$ wt% to $\leq 3$ wt%, based on 100 wt% of the second positive electrode active material layer, and an amount of the second conductive material may be in a range of $\geq 0.1$ wt% to $\leq 5$ wt%, or of $\geq 0.5$ wt% to $\leq 3$ wt%, based on 100 wt% of the second positive electrode active material layer.

A thickness of the second positive electrode active material layer may be in a range of $\geq 20$ $\mu$m to $\leq 200$ $\mu$m, for example of $\geq 40$ $\mu$m to $\leq 150$ $\mu$m, or of $\geq 60$ $\mu$m to $\leq 100$ $\mu$m. The thickness of the second positive electrode active material layer may be measured by photographing a cross-section of the positive electrode using, e.g., a scanning electron microscope. When the thickness of the second positive electrode active material layer is not constant, the average value of the lowest thickness and the largest thickness may be calculated, and in this case, the thickness may be the average thickness.

A loading level of the second positive electrode active material layer may be in a range of $\geq 5$ mg/cm$^2$ to $\leq 25$ mg/cm$^2$, for example of $\geq 7$ mg/cm$^2$ to $\leq 23$ mg/cm$^2$, of $\geq 9$ mg/cm$^2$ to $\leq 21$ mg/cm$^2$, or of $\geq 10$ mg/cm$^2$ to $\leq 20$ mg/cm$^2$.

A total mixture density of the first positive electrode active material layer and the second positive electrode active material layer may be in a range of $\geq 2.0$ g/cc to $\leq 4.0$ g/cc, for example of $\geq 2.2$ g/cc to $\leq 3.8$ g/cc, of $\geq 2.4$ g/cc to $\leq 3.6$ g/cc, or of $\geq 2.6$ g/cc to $\leq 3.4$ g/cc.

In addition to the above-described configurations, the first positive electrode active material layer and the second positive electrode active material layer may further include known components within a range that does not impair the performance of the battery.

## Rechargeable Lithium Battery

In some example embodiments, a rechargeable lithium battery includes the aforementioned positive electrode, negative electrode, and electrolyte.

The rechargeable lithium battery may include a positive electrode, a negative electrode, a separator between the positive electrode and the negative electrode, and an electrolyte.

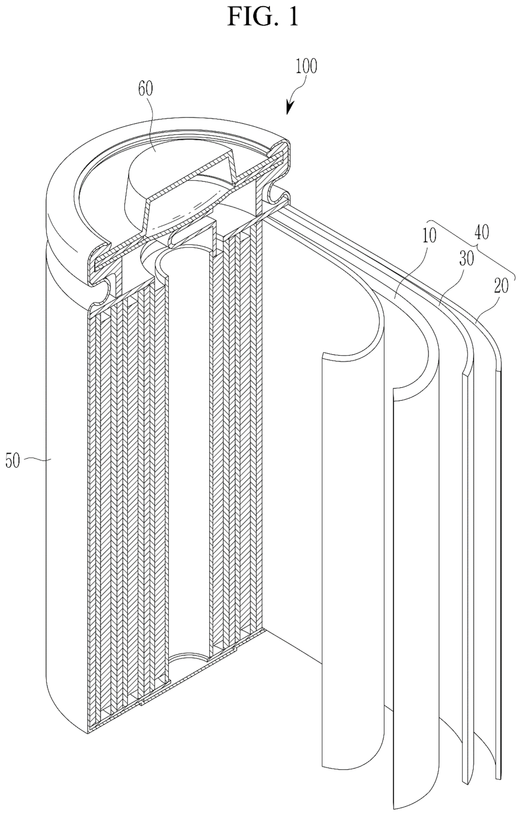

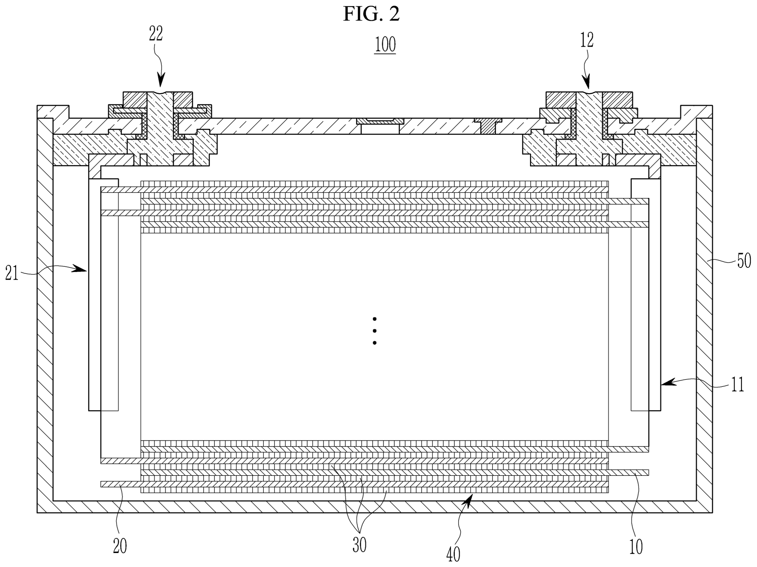

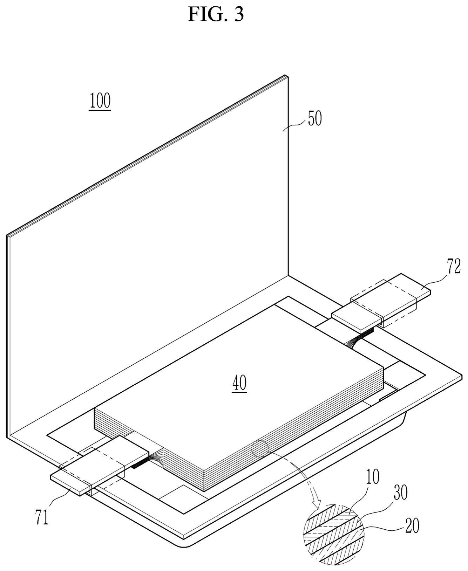

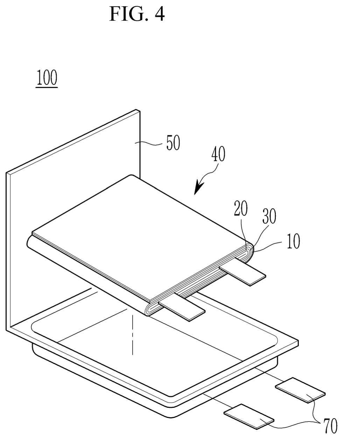

The rechargeable lithium battery may be classified into cylindrical, prismatic, pouch, coin, and the like, depending on the shape. FIGS. 1 to 4 are schematic diagrams showing the rechargeable lithium battery according to some example embodiments, where FIG. 1 is a cylindrical battery, FIG. 2 is a prismatic battery, and FIGS. 3 and 4 are a pouch-shaped battery. Referring to FIGS. 1 to 4, the rechargeable lithium battery 100 includes an electrode assembly 40 with a separator 30 interposed between the positive electrode 10 and the negative electrode 20, and a case 50 in which the electrode assembly 40 is housed. The positive electrode 10, the negative electrode 20, and the separator 30 may be impregnated with an electrolyte (not shown). The rechargeable lithium battery 100 may include a sealing member 60 that seals the case 50 as shown in FIG. 1. Additionally, in FIG. 2, the rechargeable lithium battery 100 may include a positive electrode lead tab 11, a positive electrode terminal 12 connected to the positive electrode lead tab 11, a negative electrode lead tab 21, and a negative electrode terminal 22 connected to the negative electrode lead tab 21. As shown in FIGS. 3 and 4, the rechargeable lithium battery 100 includes an electrode tab 70 illustrated in FIG. 4, or a positive electrode tab 71 and a negative electrode tab 72 illustrated in FIG. 3, the electrode tabs 70/71/72 forming an electrical path for inducing the current formed in the electrode assembly 40 to the outside of the battery 100.

Negative Electrode

The negative electrode for a rechargeable lithium battery includes a negative electrode current collector, and a negative electrode active material layer on the negative electrode current collector. The negative electrode active material layer includes a negative electrode active material, and may optionally further include at least one of a binder, a conductive material, or a combination thereof.

The negative electrode current collector is not particularly limited, as long as the negative electrode current collector has conductivity and does not cause a chemical change in the rechargeable lithium battery, and may be or include a copper foil having a thickness in a range of $\geq 10$ $\mu$m to $\leq 15$ $\mu$m.

The negative electrode active material includes at least one of a material capable of reversibly intercalating/-deintercalating lithium ions, lithium metal, an alloy of lithium metal, a material capable of doping and dedoping lithium, or a transition metal oxide.

The material capable of reversibly intercalating/deintercalating the lithium ions may be or include a carbon-based negative electrode active material, for example, crystalline carbon, amorphous carbon, or a combination thereof. The crystalline carbon may be irregular, or sheet, flake, spherical, or fiber-shaped natural graphite or artificial graphite. The amorphous carbon may be or include at least one of a soft carbon, a hard carbon, a mesophase pitch carbonization product, calcined coke, and the like.

As the lithium metal alloy, an alloy of lithium and a metal such as or including at least one of Na, K, Rb, Cs, Fr, Be, Mg, Ca, Sr, Si, Sb, Pb, In, Zn, Ba, Ra, Ge, Al, and Sn may be used.

The material capable of doping/dedoping lithium may be or include a Si-based negative electrode active material or a Sn-based negative electrode active material. The Si-based negative electrode active material may be or include at least one of silicon, a silicon-carbon composite, SiOx (0<x≤2), a Si-Q alloy (wherein Q is or includes at least one of an alkali metal, an alkaline earth metal, a Group 13 element, a Group 14 element (excluding Si), a Group 15 element, a Group 16 element, a transition metal, a rare earth element, and a combination thereof, and for example, includes at least one of Mg, Ca, Sr, Ba, Ra, Sc, Y, Ti, Zr, Hf, Rf, V, Nb, Ta, Db, Cr, Mo, W, Sg, Tc, Re, Bh, Fe, Pb, Ru, Os, Hs, Rh, Ir, Pd, Pt, Cu, Ag, Au, Zn, Cd, B, Al, Ga, Sn, In, Tl, Ge, P, As, Sb, Bi, S, Se, Te, Po, and a combination thereof), or a combination thereof. The Sn-based negative electrode active material may be or include at least one of Sn, $SnO_2$, a Sn alloy, or a combination thereof.

The silicon-carbon composite may be or include a composite of silicon and amorphous carbon. The average particle diameter ($D_{50}$) of the silicon-carbon composite particles may be, for example, in a range of ≥ 0.5 μm to ≤ 20 μm. According to some example embodiments, the silicon-carbon composite may be in the form of silicon particles and amorphous carbon coated on the surface of the silicon particles. For example, the silicon-carbon composite may include a secondary particle (core) in which silicon primary particles are assembled, and an amorphous carbon coating layer (shell) on the surface of the secondary particle. The amorphous carbon may also be present between the silicon primary particles, for example, the silicon primary particles may be coated with amorphous carbon. The secondary particles may be dispersed in an amorphous carbon matrix.

The silicon-carbon composite may further include crystalline carbon. For example, the silicon-carbon composite may include a core including crystalline carbon and silicon particles, and an amorphous carbon coating layer on the surface of the core. The crystalline carbon may be or include artificial graphite, natural graphite, or a combination thereof. The amorphous carbon may include at least one of soft carbon or hard carbon, a mesophase pitch carbonized product, calcined coke, and the like.

When the silicon-carbon composite includes silicon and amorphous carbon, an amount of the silicon may be in a range of ≥ 10 wt% to ≤ 50 wt%, and an amount of the amorphous carbon may be in a range of ≥ 50 wt% to ≤ 90 wt% based on 100 wt% of the silicon-carbon composite. In addition, when the composite includes silicon, amorphous carbon, and crystalline carbon, an amount of silicon may be in a range of ≥ 10 wt% to ≤ 50 wt%, an amount of crystalline carbon may be of ≥ 10 wt% to ≤ 70 wt%, and an amount of amorphous carbon may be of ≥ 20 wt% to ≤ 40 wt% based on 100 wt% of the silicon-carbon composite.

Additionally, a thickness of the amorphous carbon coating layer may be in a range of ≥ 5 nm to ≤ 100 nm. An average particle diameter ($D_{50}$) of the silicon particles (primary particles) may be in a range of ≥ 10 nm to ≤ 1 μm, or of ≥ 10 nm to ≤ 200 nm. The silicon particles may be present as silicon alone, in the form of a silicon alloy, or in an oxidized form. The oxidized form of the silicon may be represented as $SiO_x$ (0<x<2). At this time, the atomic content ratio of Si:O, which indicates the degree of oxidation, may be in a range of about 99:1 to about 33:67. In the present specification, as used herein, when a definition is not otherwise provided, an average particle diameter ($D_{50}$) indicates a diameter of a particle where an accumulated volume is about 50 volume% in a particle size distribution.

The Si-based negative electrode active material or Sn-based negative electrode active material may be mixed with the carbon-based negative electrode active material. When using a mixture of a Si-based negative electrode active material or a Sn-based negative electrode active material and a carbon-based negative electrode active material, the mixing ratio may be in a range of about 1:99 to about 90:10 by weight.

The negative electrode active material may be included in an amount in a range of ≥ 90 wt% to ≤ 99.8 wt%, or of ≥ 94 wt% to ≤ 99 wt%, based on 100 wt% of the negative electrode active material layer.

The binder is configured to adhere the negative electrode active material particles to each other, and to adhere the negative electrode active material to the current collector. The binder may be or include a non-aqueous binder, an aqueous binder, a dry binder, or a combination thereof.

The non-aqueous binder may include at least one of polyvinylchloride, carboxylated polyvinylchloride, polyvinylfluoride, an ethylene propylene copolymer, polystyrene, polyurethane, polytetrafluoroethylene, polyvinylidene fluoride, polyethylene, polypropylene, polyamideimide, polyimide, or a combination thereof.

The aqueous binder may include at least one of a styrene-butadiene rubber, a (meth)acrylated styrene-butadiene rubber, a (meth)acrylonitrile-butadiene rubber, a (meth)acrylic rubber, a butyl rubber, a fluorine rubber, polyethylene oxide, polyvinylpyrrolidone, polyepichlorohydrin, polyphosphazene, poly(meth)acrylonitrile, an ethylene propylene diene copolymer, polyvinylpyridine, chlorosulfonated polyethylene, latex, a polyester resin, a (meth)acrylic resin, a phenol resin, an epoxy resin, polyvinyl alcohol, or a combination thereof.

When an aqueous binder is used as the negative electrode binder, a cellulose-based compound capable of imparting viscosity may be further included. As the cellulose-based compound, one or more of carboxymethyl cellulose, hydroxypropylmethyl cellulose, methyl cellulose, or alkali metal salts thereof may be mixed and used. The alkali metal may be or include at least one of Na, K, or Li.

The dry binder may be or include a polymer material capable of becoming fiber, and may be or include, for example, at least one of polytetrafluoroethylene, polyvinylidene fluoride, a vinylidene fluoride-hexafluoropropylene copolymer, polyethylene oxide, or a combination thereof.

The conductive material is included to provide electrode conductivity, and any electrically conductive material may be used as a conductive material unless the electrically conductive material causes a chemical change in the battery. Examples of the conductive material include a carbon-based material such as at least one of natural graphite, artificial graphite, carbon black, acetylene black, Ketjen black, a carbon fiber, a carbon nanofiber, a carbon nanotube, and the like; a metal-based material of a metal powder or a metal fiber including at least one of copper, nickel, aluminum silver, and the like; a conductive polymer such as a polyphenylene derivative; or a mixture thereof.

An amount of the binder may be in a range of $\geq 0.1$ wt% to $\leq 5$ wt% based on 100 wt% of the negative electrode active material layer, and an amount of the conductive material may be in a range of $\geq 0.1$ wt% to $\leq 5$ wt% based on 100 wt% of the negative electrode active material layer.

Electrolyte

For example, the electrolyte for a rechargeable lithium battery may be an electrolyte solution, which may include a non-aqueous organic solvent and a lithium salt.

The non-aqueous organic solvent is configured as a medium for transmitting ions taking part in the electrochemical reaction of a battery. The non-aqueous organic solvent may be or include at least one of a carbonate-based, ester-based, an ether-based, a ketone-based, an alcohol-based solvent, an aprotic solvent, or a combination thereof.

The carbonate-based solvent may include at least one of dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like. The ester-based solvent may include at least one of methyl acetate, ethyl acetate, n-propyl acetate, dimethyl acetate, methyl propionate, ethyl propionate, decanolide, mevalonolactone, valerolactone, caprolactone, and the like. The ether-based solvent may include at least one of dibutyl ether, tetraglyme, diglyme, dimethoxyethane, 2-methyltetrahydrofuran, 2,5-dimethyltetrahydrofuran, tetrahydrofuran, and the like. In addition, the ketone-based solvent may include cyclohexanone, and the like. The alcohol-based solvent may include ethanol, isopropyl alcohol, and the like. The aprotic solvent may include at least one of nitriles such as R-CN (wherein R is a C2 to C20 linear, branched, or cyclic hydrocarbon group, a double bond, an aromatic ring, or an ether group, and the like); amides such as dimethylformamide; dioxolanes such as 1,3-dioxolane, 1,4-dioxolane, and the like; sulfolanes, and the like.

The non-aqueous organic solvent may be used alone or in combination of two or more solvents, and when two or more types of solvents are used in combination, the mixing ratio may be adjusted as desired depending on intended battery performance, which is widely understood by those working in the relevant field.

When using a carbonate-based solvent, a cyclic carbonate and a chain carbonate may be mixed, and the cyclic carbonate and the chain carbonate may be mixed in a volume ratio in a range of about 1:1 to about 1:9.

The non-aqueous organic solvent may further include an aromatic hydrocarbon-based organic solvent. For example, a carbonate-based solvent and an aromatic hydrocarbon-based organic solvent may be mixed and used in a volume ratio in a range of about 1:1 to about 30:1.

The electrolyte solution may further include at least one of vinylethyl carbonate, vinylene carbonate, or an ethylene carbonate-based compound to improve battery cycle-life.

Examples of the ethylene carbonate-based compound may include at least one of fluoroethylene carbonate, difluoroethylene carbonate, chloroethylene carbonate, dichloroethylene carbonate, bromoethylene carbonate, dibromoethylene carbonate, nitroethylene carbonate, and cyanoethylene carbonate.

The lithium salt dissolved in the organic solvent is configured to supply lithium ions in a battery, to enable operation of a rechargeable lithium battery, and to improve transportation of the lithium ions between positive and negative electrodes. Examples of the lithium salt may include at least one of $LiPF_6$, $LiBF_4$, $LiSbF_6$, $LiAsF_6$, $LiClO_4$, $LiAlO_2$, $LiAlCl_4$, $LiPO_2F_2$, LiCl, LiI, $LiN(SO_3C_2F_5)_2$, $Li(FSO_2)_2N$ (lithium bis(fluorosulfonyl) imide; LiFSI), $LiC_4F_9SO_3$, $LiN(C_xF_{2x+1}SO_2)$ $(C_yF_{2y+1}SO_2)$ (wherein x and y are integers of 1 to 20), lithium trifluoromethane sulfonate, lithium tetrafluoroethane sulfonate, lithium difluorobis(oxalato) phosphate (LiDFBOP), and lithium bis(oxalato) borate (LiBOB).

A concentration of lithium salt may be within the range of $\geq 0.1$ M to $\leq 2.0$ M. When the concentration of lithium salt is within the above range, the electrolyte solution has desired ionic conductivity and viscosity, and thus desired or improved performance can be achieved and lithium ions can move effectively.

Separator

Depending on the type of the rechargeable lithium battery, a separator may be present between the positive electrode and the negative electrode. The separator may include at least one of polyethylene, polypropylene, polyvinylidene fluoride, or a multilayer film of two or more layers thereof, and a mixed multilayer film such as a polyethylene/polypropylene two-layer separator, polyethylene/polypropylene/polyethylene three-layer separator, polypropylene/-

polyethylene/polypropylene three-layer separator, and the like.

The separator may include a porous substrate and a coating layer including an organic material, an inorganic material, or a combination thereof, on one surface, or on both surfaces, of the porous substrate.

The porous substrate may be a polymer film formed of or including any one polymer such as at least one of polyolefin such as polyethylene and polypropylene, polyester such as polyethylene terephthalate and polybutylene terephthalate, polyacetal, polyamide, polyimide, polycarbonate, polyether ketone, polyarylether ketone, polyetherimide, polyamideimide, polybenzimidazole, polyethersulfone, polyphenylene oxide, a cyclic olefin copolymer, polyphenylene sulfide, polyethylene naphthalate, a glass fiber, and polytetrafluoroethylene(for example, TEFLON®), or a copolymer or mixture of two or more thereof.

The porous substrate may have a thickness in a range of $\geq 1\ \mu m$ to $\leq 40\ \mu m$, for example, of $\geq 1\ \mu m$ to $\leq 30\ \mu m$, of $\geq 1\ \mu m$ to $\leq 20\ \mu m$, of $\geq 5\ \mu m$ to $\leq 15\ \mu m$, or of $\geq 10\ \mu m$ to $\leq 15\ \mu m$.

The organic material may include a (meth)acrylic copolymer including a first structural unit derived from (meth)acrylamide, and a second structural unit including at least one of a structural unit derived from (meth)acrylic acid or (meth)acrylate, and a structural unit derived from (meth)acrylamidosulfonic acid or a salt thereof.

The inorganic material may include inorganic particles such as or including at least one of $Al_2O_3$, $SiO_2$, $TiO_2$, $SnO_2$, $CeO_2$, MgO, NiO, CaO, GaO, ZnO, $ZrO_2$, $Y_2O_3$, $SrTiO_3$, $BaTiO_3$, $Mg(OH)_2$, boehmite, and a combination thereof, but is not limited thereto. An average particle diameter ($D_{50}$) of the inorganic particles may be in a range of $\geq 1$ nm to $\leq 2000$ nm, for example, of $\geq 100$ nm to $\leq 1000$ nm, or of $\geq 100$ nm to $\leq 700$ nm.

The organic material and the inorganic material may be mixed in one coating layer, or a coating layer including an organic material and a coating layer including an inorganic material may be stacked together.

A thickness of the coating layer may be in a range of $\geq 0.5\ \mu m$ to $\leq 20\ \mu m$, for example, of $\geq 1\ \mu m$ to $\leq 10\ \mu m$, or of $\geq 1\ \mu m$ to $\leq 5\ \mu m$.

Examples and comparative examples of the present disclosure are described below. However, the following examples are only examples of the present disclosure, and the present disclosure is not limited to the following examples.

## Example 1

### (1) Manufacturing of Positive Electrode

A lithium iron phosphate-based compound ($LiFePO_4$) in the form of secondary particles having an average particle diameter ($D_{50}$) of 8 $\mu m$, in which a plurality of primary particles having an average particle diameter ($D_{50}$) of 200 nm were agglomerated, as a first positive electrode active material, polyvinylidene fluoride as a first binder, and carbon black as a first conductive material were mixed in a weight ratio of 95:2.5:2.5 (first positive electrode active material : first binder : first conductive material) to prepare a first positive electrode active material layer composition. This composition was dispersed in an N-methyl pyrrolidone solvent to prepare a first positive electrode active material layer slurry.

A second positive electrode active material layer composition was prepared by mixing a lithium nickel-based composite oxide ($LiNi_{0.885}Mn_{0.1}Al_{0.015}O_2$) of large secondary particles with an average particle diameter ($D_{50}$) of 14 $\mu m$ in which a plurality of primary particles were agglomerated and lithium nickel-based composite oxide ($LiNi_{0.885}Mn_{0.1}Al_{0.015}O_2$) of small secondary particles with an average particle diameter ($D_{50}$) of 4 $\mu m$ in a weight ratio of 3:1 to prepare a second positive electrode active material, mixing the second positive electrode active material with a third positive electrode active material of a lithium manganese-based oxide ($LiMn_2O_4$) in the form of single particles with an average particle diameter ($D_{50}$) of 7.5 $\mu m$ in a weight ratio of 31.75:68.25, and then mixing the mixture with polyvinylidene fluoride as a second binder and carbon black as a second conductive material in a weight ratio of 98.5:1:0.5 (mixture : second binder : second conductive material). This composition was dispersed in an N-methyl pyrrolidone solvent to prepare a second positive electrode active material layer slurry.

The first positive electrode active material layer slurry was coated on a 15 $\mu m$-thick aluminum thin film and then, dried to form a first positive electrode active material layer, and the second positive electrode active material layer slurry was coated on the first positive electrode active material layer, and then dried to form a second positive electrode active material layer. Subsequently, a positive electrode was manufactured by roll-pressing a stack of positive electrode current collector-first positive electrode active material layer-second positive electrode active material layer in order.

Herein, based on 100 wt% of a total amount of the first positive electrode active material, the second positive electrode active material, and the third positive electrode active material, a weight percentage of the first positive electrode active material was 37 wt%, the second positive electrode active material was 20 wt%, and the third positive electrode active material was 43 wt%. The first positive electrode active material layer had a loading level of about 7.4 mg/cm$^2$, and the second positive electrode active material layer had a loading level of 12.6 mg/cm$^2$. In addition, the first positive electrode active material layer and the second positive electrode active material layer had total mixture density of about 3 g/cc.

**(2) Manufacturing of Rechargeable Lithium Battery Cell**

97.5 wt% of a graphite negative electrode active material, 1.5 wt% of carboxymethyl cellulose, and 1 wt% of styrene butadiene rubber were mixed in a water solvent to prepare a negative electrode active material layer slurry. The negative electrode active material layer slurry was coated on a 12 $\mu$m-thick copper foil current collector, and then dried and compressed to manufacture a negative electrode.

The prepared positive and negative electrodes were used to manufacture a coin half-cell. A polypropylene film (Celgard 3510) was used as a separator, and an electrolyte was prepared by mixing ethylene carbonate, diethyl carbonate, and fluoroethylene carbonate in a volume ratio of 2:6:2, and then dissolving 1.3 M $LiPF_6$ in the mixed solvent.

**Comparative Example 1**

A positive electrode and a rechargeable lithium battery cell were manufactured substantially in the same manner as in Example 1, with a difference that the first positive electrode active material layer slurry was coated on a 15 $\mu$m-thick aluminum thin film, and then dried and compressed to form a positive electrode active material layer. The positive electrode of Comparative Example 1 had a single-layer structure of positive electrode current collector-positive electrode active material layer. The positive electrode active material layer had a loading level of 20 mg/cm$^2$ and mixture density of 2.4 g/cc.

**Comparative Example 2**

A positive electrode and a rechargeable lithium battery cell were manufactured substantially in the same manner as in Example 1, with a difference that the second positive electrode active material, polyvinylidene fluoride as a binder and carbon black as a conductive material were mixed in a weight ratio of 95:2.5:2.5 (second positive electrode active material : binder : conductive material) to prepare a positive electrode active material composition, and the positive electrode active material composition was dispersed in an N-methyl pyrrolidone solvent to prepare a positive electrode active material slurry, which was coated on a 15 $\mu$m-thick aluminum thin film, and then dried and compressed to form a positive electrode active material layer. The positive electrode of Comparative Example 2 had a single-layer structure of positive electrode current collector-positive electrode active material layer stacked in order. The positive electrode active material layer had a loading level of 20 mg/cm$^2$ and mixture density of 3.7 g/cc.

**Comparative Example 3**

A positive electrode and a rechargeable lithium battery cell were manufactured substantially in the same manner as in Example 1, with a difference that the third positive electrode active material, polyvinylidene fluoride as a binder, and carbon black as a conductive material were mixed in a weight ratio of 95:2.5:2.5 (third positive electrode active material : binder : conductive material) to prepare a positive electrode active material composition, and this composition was dispersed in an N-methyl pyrrolidone solvent to prepare a positive electrode active material slurry, which was coated on a 15 $\mu$m-thick aluminum thin film, and then dried and compressed to form a positive electrode active material layer. The positive electrode of Comparative Example 3 had a single-layer structure of positive electrode current collector-positive electrode active material layer stacked in order. The positive electrode active material layer had a loading level of 20 mg/cm$^2$ and mixture density of 2.8 g/cc.

**Comparative Example 4**

A positive electrode and a rechargeable lithium battery cell were manufactured substantially in the same manner as in Example 1, with a difference that a mixture of the first positive electrode active material and the second positive electrode active material in a weight ratio of 80:20, polyvinylidene fluoride as a binder, and carbon black as a conductive material were mixed in a weight ratio of 95:2.5:2.5 (positive electrode active material : binder : conductive material) to prepare a positive electrode active material composition, and this composition was dispersed in an N-methyl pyrrolidone solvent to prepare a positive electrode active material slurry, which was coated on a 15 $\mu$m-thick aluminum thin film, and then dried and compressed to form a positive electrode active material layer. The positive electrode of Comparative Example 4 had a single-layer structure of positive electrode current collector-positive electrode active material layer stacked in order. The positive electrode active material layer had a loading level of 20 mg/cm$^2$ and mixture density of 3 g/cc.

**Comparative Example 5**

A positive electrode and a rechargeable lithium battery cell were manufactured substantially in the same manner as in Example 1, with a difference that a mixture of the first positive electrode active material, the second positive electrode active material, and the third positive electrode active material in a weight ratio of 37:20:43, polyvinylidene fluoride as a binder, and carbon black as a conductive material were mixed in a weight ratio of 95:2.5:2.5 (positive electrode active material : binder : conductive material) to prepare a positive electrode active material composition, and this composition was dispersed in an N-methyl pyrrolidone solvent to prepare a positive electrode active material slurry, which was coated on a 15 $\mu$m-thick aluminum thin film, and then dried and compressed to form a positive electrode active material layer. The positive electrode of Comparative Example 5 had a single-layer structure of positive electrode current collector-positive electrode active material layer stacked in order. The positive electrode active material layer had a loading level of 20 mg/cm$^2$ and mixture density of 3 g/cc.

## Comparative Example 6

A positive electrode and a rechargeable lithium battery cell were manufactured substantially in the same manner as in Example 1, with a difference that the positive electrode was manufactured to have an order of positive electrode current collector-second positive electrode active material layer-first positive electrode active material layer by changing the stacking order of the first positive electrode active material layer and the second positive electrode active material layer. The first positive electrode active material layer had a loading level of 12.6 mg/cm$^2$, and the second positive electrode active material layer had a loading level of 7.4 mg/cm$^2$. In addition, the first positive electrode active material layer and the second positive electrode active material layer had total mixture density of 3 g/cc.

## Evaluation Example: Battery Cell Performance Evaluation

Hereinafter, evaluation voltages in the evaluation examples are shown Table 1 below.

Table 1:

|  | Evaluation voltage (cut-off voltage - upper limit voltage) (V) |
| --- | --- |
| Example 1 | 3-4.25 |
| Comparative Example 1 | 2.5-3.65 |
| Comparative Example 2 | 2.5-4.25 |
| Comparative Example 3 | 3-4.25 |
| Comparative Example 4 | 2.5-4.25 |
| Comparative Example 5 | 3-4.25 |
| Comparative Example 6 | 3-4.25 |

### (1) Measurement of Initial Charge/discharge Capacity and Efficiency

The rechargeable lithium battery cells of Example 1 and Comparative Examples 1 to 6 were respectively constant current-charged at 0.2 C-rate to a cut-off voltage shown in Table 1 and constant current-discharged at 0.2 C-rate to an upper limit voltage shown in Table 1 at 25 °C for initial charge/discharge to measure initial charge/discharge capacity, which was used to calculate initial charge and discharge efficiency according to Equation 1 below, and the results are shown in Table 2 below.

Initial charge and discharge efficiency [%] = [Discharge capacity in 1$^{st}$ cycle / Charge capacity in 1$^{st}$ cycle] $\times$ 100      Equation 1:

### (2) Average Voltage Measurement

The rechargeable lithium battery cells of Example 1 and Comparative Examples 1 to 6 were measured with respect to average voltages in SOC (State Of Charge) of 50% during the initial discharge, which are shown as cycle-life in Table 2 below.

### (3) Cycle-life Characteristics

The rechargeable lithium battery cells of Example 1 and Comparative Examples 1 to 6 were 50 cycles or more charged and discharged at 1.0 C-rate within the voltage ranges shown in Table 1 subsequently after the initial charge and discharge, and then a ratio of 50th cycle discharge capacity to the initial discharge capacity was calculated according to Equation 2 below and then, shown in Table 2 below.

Cycle-life [%] = [Discharge capacity at 50th cycle / Discharge capacity at 1st cycle] $\times$ 100          Equation 2:

### (4) Rate Capability

The rechargeable lithium battery cells of Example 1 and Comparative Examples 1 to 6 were charged and discharged at 1.0 C-rate subsequently after the initial charge and discharge at 0.2 C-rate. A ratio of discharge capacity at 1.0 C-rate to that at 0.2 C-rate was calculated according to Equation 3 below, which is shown as rate capacity in Table 2 below.

Rate capability [%] = [Discharge capacity at 1.0 C-rate / Discharge capacity at 0.2 C-rate] $\times$ 100          Equation 3:

Table 2:

| | Initial charge and discharge | | | Average voltage (V) | Cycle-life (%, @50 cy) | Rate capability (%, 1 C/ 0.2 C) |
|---|---|---|---|---|---|---|
| | 0.2C-rate charge capacity (mAh/g) | 0.2C-rate discharge capacity (mAh/g) | Initial charge and discharge efficiency (%) | | | |
| Example 1 | 154.8 | 145.5 | 94.0 | 3.61 | 99.5 | 95.8 |
| Comparative Example 1 | 166.3 | 162.1 | 97.5 | 3.20 | 97.8 | 94.0 |
| Comparative Example 2 | 234.2 | 208.5 | 88.9 | 3.65 | 97.0 | 94.7 |
| Comparative Example 3 | 106 | 104 | 98.1 | 3.95 | 98.4 | 99.0 |
| Comparative Example 4 | 177 | 164.3 | 92.8 | 3.28 | 97.9 | 90.1 |
| Comparative Example 5 | 154.4 | 143.8 | 93.2 | 3.61 | 98.2 | 93.1 |
| Comparative Example 6 | 154.1 | 143.3 | 92.9 | 3.61 | 98.1 | 92.1 |

### Conclusion

Referring to Table 2, in the case of the rechargeable lithium battery cell including the positive electrode of Example 1, which has a double-layer structure in which a first positive electrode active material layer including a first positive electrode active material including a lithium iron phosphate-based compound is stacked as a lower layer, and a second positive electrode active material layer including a second positive electrode active material including a lithium nickel-based composite oxide and a third positive electrode active material including a lithium manganese-based oxide is stacked as an upper layer, the initial charge and discharge efficiency, cycle-life, and rate capability were improved, compared to the rechargeable lithium battery cell including the positive electrode of Comparative Example 5, which includes a single positive electrode active material layer prepared by mixing the first positive electrode active material, the second positive electrode active material, and the third positive electrode active material. Accordingly, battery performance was improved when the double-layer structure was adopted rather than simple mixing.

On the other hand, compared with the rechargeable lithium battery cell including the positive electrode with the double-layer structure of the first positive electrode active material layer as a lower layer and the second positive electrode active material layer containing the second positive electrode active material and the third positive electrode active material as an upper layer according to Example 1, the rechargeable lithium battery including the positive electrode with the double-layer structure of the first positive electrode active material layer as an upper layer and the second positive electrode active material layer as a lower layer according to Comparative Example 6 exhibited significantly deteriorated initial charge and discharge efficiency, cycle-life, and rate capability, and in particular significantly deteriorated rate capability. Accordingly, rate capability and cycle-life characteristics of a battery can be improved by adopting the double-layer structure, and in particular by placing the lithium nickel-based composite oxide and the lithium manganese-based oxide exhibiting high capacity at high voltages as an upper layer where an electrochemical reaction most actively occurs, while placing the lithium iron phosphate-based compound exhibiting capacity at relatively low voltages as a low layer.

While this disclosure has been described in connection with what is presently considered to be practical example embodiments, it is to be understood that the disclosure is not limited to the disclosed example embodiments, but, on the contrary, is intended to cover various modifications and equivalent arrangements included within the spirit and scope of the appended claims.

**Description of Symbols:**

1: positive electrode current collector
2: first positive electrode active material layer
3: second positive electrode active material layer
4: positive electrode
100: rechargeable lithium battery
10: positive electrode
11: positive electrode lead tab
12: positive electrode terminal
20: negative electrode
21: negative electrode lead tab
22: negative electrode terminal
30: separator
40: electrode assembly
50: case
60: sealing member
70: electrode tab
71: positive electrode tab
72: negative electrode tab

**Claims**

1. A positive electrode (4) for a rechargeable lithium battery (100), the positive electrode (4) comprising:

   a positive electrode current collector (1);
   a first positive electrode active material layer (2) on the positive electrode current collector (1) and including a first positive electrode active material including a lithium iron phosphate-based compound; and
   a second positive electrode active material layer (3) on the first positive electrode active material layer (2) and that comprises a second positive electrode active material including a lithium nickel-based composite oxide and a third positive electrode active material including a lithium manganese-based oxide.

2. The positive electrode (4) as claimed in claim 1, wherein the lithium iron phosphate-based compound is represented by one of Chemical Formula 1 and Chemical Formula 2;

$$\text{Chemical Formula 1:} \quad \text{Li}_{a1}\text{Fe}_{(1-x1)}\text{M}^1_{x1}\text{PO}_4$$

wherein, in Chemical Formula 1, $0.9 \leq a1 \leq 1.5$, $0 \leq x1 \leq 0.4$, and $\text{M}^1$ comprises at least one of Al, Ca, Ce, Cr, Cu, La, Mg, Mn, Mo, Nb, Ni, Sn, Sr, Ti, V, W, Y, Zn, and Zr,

$$\text{Chemical Formula 2:} \quad \text{Li}_{a2}\text{Mn}_{x2}\text{Fe}_{(1-x2-y2)}\text{M}^2_{y2}\text{PO}_4$$

wherein, in Chemical Formula 2, $0.9 \leq a2 \leq 1.5$, $0.1 \leq x2 \leq 0.9$, $0 \leq y2 < 0.9$, and $\text{M}^2$ comprises at least one of Al, Ca, Ce, Cr, Cu, La, Mg, Mo, Nb, Ni, Sn, Sr, Ti, V, W, Y, Zn, and Zr.

3. The positive electrode (4) as claimed in claim 1 or 2, wherein:

   the first positive electrode active material comprises one of first particles, second particles, and a mixture thereof, the first particles comprise secondary particles formed by agglomeration of a plurality of primary particles, and the second particles are in a form of single particles;
   wherein preferably:

an average particle diameter ($D_{50}$) of the secondary particles of the first particles is in a range of $\geq 5 \,\mu m$ to $\leq 20 \,\mu m$,

an average particle diameter ($D_{50}$) of the primary particles forming the secondary particles is in a range of $\geq 0.1 \,\mu m$ to $\leq 2 \,\mu m$, and

an average particle diameter ($D_{50}$) of the single particles of the second particles is in a range of $\geq 0.5 \,\mu m$ to $\leq 5 \,\mu m$; and/or

wherein an amount of the first particles is in a range of $\geq 20 \,wt\%$ to $\leq 100 \,wt\%$; and

an amount of the second particles is in a range of $\geq 0 \,wt\%$ to $\leq 80 \,wt\%$ based on 100 wt% of the first positive electrode active material.

4. The positive electrode (4) as claimed in claim 3, wherein the first positive electrode active material further comprises at least one of:

a carbon coating layer formed on a surface of the secondary particles of the first particles,

a carbon coating layer formed on a surface of the primary particles forming the secondary particles of the first particles, and

a carbon coating layer formed on a surface of the single particles of the second particles;

wherein optional:

the carbon coating layer is included in an amount in a range of $\geq 0.1 \,wt\%$ to $\leq 3.9 \,wt\%$ based on 100 wt% of the first particles, and

the carbon coating layer is included in an amount in a range of $\geq 0.1 \,wt\%$ to $\leq 3.9 \,wt\%$ based on 100 wt% of the second particles.

5. The positive electrode (4) as claimed in any one of claims 1 to 4, wherein the lithium nickel-based composite oxide of the second positive electrode active material is represented by Chemical Formula 3:

Chemical Formula 3: $\quad Li_{a3}Ni_{x3}M^3{}_{y3}M^4{}_{z3}O_{2-b}{}^3X_{b3}$

wherein, in Chemical Formula 3, $0.9 \leq a3 \leq 1.2$, $0.3 \leq x3 < 1$, $0 < y3 \leq 0.7$, $0 \leq z3 \leq 0.7$, $0.9 \leq x3+y3+z3 \leq 1.1$, and $0 \leq b3 \leq 0.1$, $M^3$ and $M^4$ each independently comprises one or more of Al, B, Ba, Ca, Ce, Co, Cr, Cu, Fe, Mg, Mn, Mo, Nb, Si, Sn, Sr, Ti, V, W, Y, Zn, and Zr, and X comprises one or more of F, P, and S; and/ or wherein the lithium nickel-based composite oxide of the second positive electrode active material comprises nickel in an amount that is greater than or equal to about 80 mol% based on 100 mol% of a total metal excluding lithium nickel.

6. The positive electrode (4) as claimed in any one of claims 1 to 5, wherein the second positive electrode active material comprises at least one of large particles having an average particle diameter ($D_{50}$) in a range of $\geq 9 \,\mu m$ to $\leq 20 \,\mu m$, and small particles having an average particle diameter ($D_{50}$) in a range of $\geq 1 \,\mu m$ to $\leq 8 \,\mu m$; wherein optional:

the second positive electrode active material comprises both the large particles and the small particles, and

the large particles and the small particles are mixed in a weight ratio in a range of about 20:80 to about 95:5.

7. The positive electrode (4) as claimed in any one of claims 1 to 6, wherein the lithium manganese-based oxide is represented by Chemical Formula 6;

Chemical Formula 6: $\quad Li_{a6}Mn_{x6}M^8{}_{y6}O_{4-b6}X_{b6}$

wherein, in Chemical Formula 6, $0.9 \leq a6 \leq 1.8$, $1.7 \leq x6 \leq 2$, $0 \leq y6 \leq 0.3$, $1.9 \leq x6+y6 \leq 2.1$, and $0 \leq b6 \leq 0.1$, $M^8$ comprises one or more of Al, B, Ba, Ca, Ce, Cr, Cu, Fe, Mg, Mo, Nb, Si, Sn, Sr, Ti, V, W, Y, Zn, and Zr, and X comprises one or more of F, P, and S.

8. The positive electrode (4) as claimed in any one of claims 1 to 7, wherein:

the third positive electrode active material comprises secondary particles formed by agglomeration of one of a plurality of primary particles, single particles, and a mixture thereof;

an average particle diameter ($D_{50}$) of the secondary particles is in a range of $\geq 5 \,\mu m$ to $\leq 15 \,\mu m$, and

an average particle diameter ($D_{50}$) of the single particles is in a range of $\geq 0.1 \,\mu m$ to $\leq 10 \,\mu m$.

9.  The positive electrode (4) as claimed in any one of claims 1 to 8, wherein a weight ratio of the second positive electrode active material and the third positive electrode active material in the second positive electrode active material layer (3) is in a range of about 10:90 to about 90:10.

10. The positive electrode (4) as claimed in any one of claims 1 to 9, wherein:
    in a total of the first positive electrode active material layer (2) and the second positive electrode active material layer (3), the first positive electrode active material is included in an amount in a range of $\geq 10$ wt% to $\leq 70$ wt%, the second positive electrode active material is included in an amount in a range of $\geq 10$ wt% to $\leq 50$ wt%, and the third positive electrode active material is included in an amount in a range of $\geq 20$ wt% to $\leq 80$ wt%, based on a total of 100 wt% of the first positive electrode active material, the second positive electrode active material, and the third positive electrode active material.

11. The positive electrode (4) as claimed in any one of claims 1 to 10, wherein a manganese content in a total of the first positive electrode active material layer (2) and the second positive electrode active material layer (3) is in a range of $\geq 30$ mol% to $\leq 70$ mol% based on 100 mol% of a total metal excluding lithium.

12. The positive electrode (4) as claimed in any one of claims 1 to 11, wherein:

    the first positive electrode active material layer (2) further comprises at least one of a first binder and a first conductive material, and
    the second positive electrode active material layer (3) further comprises at least one of a second binder and a second conductive material.

13. The positive electrode (4) as claimed in any one of claims 1 to 12, wherein:

    a loading level of the first positive electrode active material layer (2) is in a range of $\geq 5$ mg/cm$^2$ to $\leq 25$ mg/cm$^2$, and
    a loading level of the second positive electrode active material layer (3) is in a range of $\geq 5$ mg/cm$^2$ to $\leq 25$ mg/cm$^2$.

14. The positive electrode (4) as claimed in any one of claims 1 to 13, wherein a total mixture density of the first positive electrode active material layer (2) and the second positive electrode active material layer (3) is in a range of $\geq 2.0$ g/cc to $\leq 4.0$ g/cc.

15. A rechargeable lithium battery (100) comprising:

    the positive electrode (4) as claimed in any one of claims 1 to 14,
    a negative electrode (20), and
    an electrolyte.

# FIG. 1

**FIG. 2**

100

EP 4 741 348 A1

FIG. 3

FIG. 4

FIG. 5

Charge/Discharge Curves

FIG. 6

<u>4</u>

Europäisches
Patentamt
European
Patent Office
Office européen
des brevets

# EUROPEAN SEARCH REPORT

**Application Number**

EP 25 21 2918

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JOBST NICOLA MICHAEL ET AL: "Ternary Cathode Blend Electrodes for Environmentally Friendly Lithium-Ion Batteries", CHEMSUSCHEM, vol. 13, no. 15, 25 June 2020 (2020-06-25), pages 3928-3936, XP093377864, DE ISSN: 1864-5631, DOI: 10.1002/cssc.202000251 * page 3929 - page 3935; figures; tables * | 1-15 | INV. C01G45/02 C01G49/00 C01G53/42 C01G53/506 H01M4/00 |
| | ----- | | |
| X | US 2009/217513 A1 (XI XIAOBING [CN] ET AL) 3 September 2009 (2009-09-03) * examples * | 1-15 | |
| | ----- | | |
| X | CN 102 683 696 A (SAMSUNG SDI CO LTD) 19 September 2012 (2012-09-19) * examples * | 1-15 | |
| | ----- | | |
| X | JP 2012 033507 A (TOSHIBA CORP) 16 February 2012 (2012-02-16) * examples * | 1-15 | TECHNICAL FIELDS SEARCHED (IPC) C01G H01M |
| | ----- | | |

The present search report has been drawn up for all claims

| Place of search | Date of completion of the search | Examiner |
|---|---|---|
| Munich | 16 March 2026 | Doslik, Natasa |

EPO FORM 1503 03.82 (P04C01)

## ANNEX TO THE EUROPEAN SEARCH REPORT
## ON EUROPEAN PATENT APPLICATION NO.

EP 25 21 2918

This annex lists the patent family members relating to the patent documents cited in the above-mentioned European search report.
The members are as contained in the European Patent Office EDP file on
The European Patent Office is in no way liable for these particulars which are merely given for the purpose of information.

16-03-2026

| Patent document cited in search report | Publication date | Patent family member(s) | Publication date |
|---|---|---|---|
| US 2009217513 A1 | 03-09-2009 | NONE | |
| CN 102683696 A | 19-09-2012 | CN 102683696 A | 19-09-2012 |
| | | CN 106816577 A | 09-06-2017 |
| | | EP 2498323 A2 | 12-09-2012 |
| | | JP 6236197 B2 | 22-11-2017 |
| | | JP 2012190786 A | 04-10-2012 |
| | | KR 20120104484 A | 21-09-2012 |
| | | US 2012231341 A1 | 13-09-2012 |
| JP 2012033507 A | 16-02-2012 | JP 5159681 B2 | 06-03-2013 |
| | | JP 5389143 B2 | 15-01-2014 |
| | | JP 2010225486 A | 07-10-2010 |
| | | JP 2012033507 A | 16-02-2012 |
| | | US 2010248038 A1 | 30-09-2010 |

EPO FORM P0459

For more details about this annex : see Official Journal of the European Patent Office, No. 12/82